# EUROPEAN PATENT APPLICATION

(11) **EP 1 030 358 A1**
(43) Date of publication of application: **23.08.2000**
(21) Application number: 98923154.3
(22) Date of filing: 05.06.1998
(51) Int. Cl.: H01L 21/60, H01L 23/29

(54) **FLIP-CHIP MEMBER, SHEETLIKE SEALING MATERIAL, SEMICONDUCTOR DEVICE, AND PROCESS FOR MANUFACTURING THE SAME**

(30) Priority: 11.06.1997 JP 15401797
(71) Applicant: Nitto Denko Corporation, Ibaraki-shi, Osaka 567-0041 (JP)
(72) Inventor: HOTTA, Yuji, Ibaraki-shi, Osaka 567-0041 (JP); SAKAMOTO, Michie, Ibaraki-shi, Osaka 567-0041 (JP); SHIMIZU, Mitsuru, Ibaraki-shi, Osaka 567-0041 (JP); MOCHIZUKI, Amane, Ibaraki-shi, Osaka 567-0041 (JP); YOSHIOKA, Masahiro, Ibaraki-shi, Osaka 567-0041 (JP); FUKUOKA, Takahiro, Ibaraki-shi, Osaka 567-0041 (JP)
(74) Representative: Grünecker, Kinkeldey, Stockmair & Schwanhäusser Anwaltssozietät
(86) International application number: JP9802512
(87) International publication number: WO9857370

(57) **Abstract**

To make possible the production of a semiconductor device having a high reliability with a high productivity by flip chip mounting, in this invention, as the flip chip sealing material, a laminated film 1 having an area being held in the inside of joining bumps formed on the electrode portion of the peripheral portion of a semiconductor element and a thickness of at least the height of the joining bumps is used. The laminated film 1 is formed by laminating each of adhesive layers 3 and 4 on both surfaces of a heat-resisting base material layer 2. As the base material layer 2, a metal foil or an organic polymer having a melting point of at least 250°C is used. As the material of the adhesive layers 3 and 4, a heat-resisting resin such as polycarbodiimide, etc., is used. By sticking the laminated film 1 to the electrode surface of the semiconductor element 5, a flip chip member is constructed. Bumps 8 are formed on the surface electrode of the semiconductor element 5. By position matching the bumps 8 of the semiconductor element 5 to circuit wires 12 of a circuit substrate 10, the semiconductor element 5 is mounted onto the circuit substrate 10 with the laminated film 1 between them by flip chip mounting.

## Description

### Technical Field

The present invention relates to a flip chip member used for flip chip mounting, a sheet-form sealing material, a semiconductor device produced by flip chip mounting, and a method of producing thereof.

### Background of the Invention

Recently, in the field of an electronics industry, the markets of information instruments typified by personal computers and potable telephones have been rapidly enlarged. In such information instruments, the requirement for light-weighing and thinning has become very strong. To cope with the requirement, flip chip mounting has been watched. In flip chip mounting, in the case of mounting a semiconductor element (chip) on a circuit substrate, bumps (projections) made of a solder material are formed on the surface electrode of the semiconductor element, and the surface electrode of the semiconductor element is directly connected to the circuit wirings on the circuit substrate via the bumps.

According to such flip chip mounting, the surface electrode of the semiconductor element is directly joined to the circuit wirings on the circuit substrate without using a lead frame and bonding wire, whereby thinning and light-weighing of a semiconductor device become possible.

In the production method of a semiconductor device using flip chip mounting as described above, a process of filling a sealing resin in the space between the semiconductor element and the circuit substrate becomes necessary at mounting the semiconductor element. This process is considered to be indispensable for improving the reliability of a semiconductor device after mounting the semiconductor element, in particular the reliability of the semiconductor device to a thermal cycle test(TCT).

In a conventional production method of semiconductor devices, a liquid thermosetting resin is coated on a circuit substrate as a sealing resin using dispenser, and after flip-chip-mounting a semiconductor element on the circuit substrate, the liquid thermosetting resin is cured by heating. Or, alternatively, after flip-chip-mounting, a liquid thermosetting resin is poured into the space between a circuit substrate and a semiconductor element and then the thermosetting resin is cured by heating.

As described above, because a liquid thermosetting resin is used, it is necessary to store the thermosetting resin in a refrigerator and to manage the shelf time thereof. Furthermore, at use the liquid thermosetting resin, a series of works must be carried out while managing the pot life thereof. Also, at flip-chip-mounting, the work of coating the liquid thermosetting resin on a circuit substrate using a dispenser or pouring the liquid thermosetting resin in the space between a circuit substrate and a semiconductor element becomes necessary. As the result thereof, the productivity of semiconductor devices is reduced.

Thus, in JP-A-5-343473 (the term "JP-A" as used herein means an "unexamined published Japanese patent application"), there is proposed a method of sticking an adhesive sheet having an adhesive layer on a film base to a wiring-formed surface of a semiconductor element and bump-joining the semiconductor element to a circuit substrate, whereby the adhesive resin is melted and pours into the space between the semiconductor element and the circuit substrate to seal the space. However, because the adhesive sheet is stuck to the whole surface of the wiring-formed surface of a semiconductor element and in the construction, joining bumps are formed on the circuit substrate side, position matching of the bumps of the semiconductor element and the joining bumps of the circuit substrate is difficult.

Also, because the adhesive sheet extends to the outside of the joining bumps, with melting and flowing of the adhesive resin, external air is liable to be taken in the space between the semiconductor element and the circuit substrate, which results in leaving bubbles in the sealed portions and thus it sometimes happens that clacks, etc., are caused in the inside of the sealed portions by a temperature change.

An object of the present invention is to provide a flip chip member capable of producing a semiconductor device having a high reliability by flip chip mounting with a high productivity and also to provide a sheet-form sealing material used therefor.

Other object of this invention is to provide a semiconductor device having a high reliability capable of being produced by flip chip mounting with a high productivity.

Still other object of this invention is to provide a method of producing a semiconductor device having a high reliability by flip chip mounting with a high productivity.

### Disclosure of the Invention

The first aspect of this invention is a flip chip member comprising a semiconductor element and a sheet-form sealing material made of an organic resin, characterized in that the sheet-form sealing material has an area being held at the inside of bumps for joining formed on the electrode portion of the peripheral portion of the semiconductor element and a thickness of at least the height of the joining bumps, and is disposed at the inside of the above-described joining bumps on the electrode surface of the semiconductor element.

In the flip chip member of this invention, the sheet-form sealing material made of an organic resin is disposed at the inside of the joining bumps on the electrode surface of a semiconductor element. Accordingly, when at flip-chip-mounting, a semiconductor element is press-stuck onto a circuit substrate, the organic resin of the sheet-form sealing material having a thickness of at least the height of the bumps flows out to the peripheral portion of the joining bumps, whereby the space between the circuit substrate and the semiconductor element and the circumference of the joining bumps are sealed and also, the semiconductor element is adhered onto the circuit substrate. In this case, because the sheet-form sealing material flows out from the inside of the joining bumps to the outside, bubbles do not exist between the circuit substrate and the semiconductor element and a semiconductor device excellent in the moisture resisting reliability and the cooling cycle resistance is obtained. On the other hand, in the sheet-form sealing material disposed up to the outside of the joining bumps as described in JP-A-5-343473, bubbles are liable to exist between a circuit substrate and a semiconductor device, whereby a semiconductor device having a high reliability as in this invention is not obtained.

Thus, a semiconductor device excellent in the moisture resisting reliability and the cooling cycle resistance is obtained. Thus, the semiconductor device having a high reliability can be produced with a high productivity. Also, because the sheet-form sealing material can be stored at room temperature and thus the management thereof becomes easy.

The second aspect of this invention is a flip chip member comprising a circuit substrate capable mounting a semiconductor element and a sheet-form sealing material made of an organic resin, characterized in that the sheet-form sealing material has an area being held at the inside of bumps for joining formed on the electrode portion of the peripheral portion of the semiconductor element and a thickness of at least the height of the joining bumps, and is disposed at the inside of the bump-joined portion of the above-described circuit substrate.

In the flip chip member of the 2nd aspect of this invention, the sheet-form sealing material made of an organic resin is disposed at the inside of the bump-joined portion of the circuit substrate. Accordingly, when at flip-chip-mounting, the semiconductor element is press-stuck onto the circuit substrate, the organic resin of the sheet-form sealing material having a thickness of at least the height of the bumps flows out to the peripheral portion of the joining bumps, whereby the space between the circuit substrate and the semiconductor element and the circumference of the joining bumps are sealed and also, the semiconductor element is adhered onto the circuit substrate in a state of covering the joining bumps. In this case, because the sheet-form sealing material flows out from the inside of the joining bumps towards the outside, bubbles do not exist between the circuit substrate and the semiconductor element and a semiconductor device excellent in the moisture resisting reliability and the cooling cycle resistance is obtained. On the other hand, in the sheet-form sealing material disposed up to the outside of the joining bumps as described in JP-A-5-343473, bubbles are liable to exist between a circuit substrate and a semiconductor device, whereby a semiconductor device having a high reliability as in this invention is not obtained.

By using the flip chip member of the second aspect this invention, a semiconductor device excellent in the moisture resisting reliability and the cooling cycle resistance is obtained. Thus, the semiconductor device having a high reliability can be produced with a high productivity. Also, because the sheet-form sealing material can be stored at room temperature and thus the management thereof becomes easy.

In particular, it is preferred that the sheet-form sealing material has a thickness of from one to three times the height of the joining bumps formed on the electrode portion at the peripheral portion of the semiconductor element.

Thereby, in the case of press-sticking the semiconductor element to the circuit substrate at flip chip mounting, the space between the circuit substrate and the semiconductor element and the circumference of the bumps are sufficiently sealed and the semiconductor element is surely adhered onto the circuit substrate.

Also, it is preferred that the sheet-form sealing material is made of a heat resisting base material having formed on both surfaces thereof a sealing material layer made of an organic resin as the main constituent. In this case, by the self-supporting property of the heat-resisting base material, handling of the sheet-form sealing material becomes easy and the semiconductor can be adhered to the semiconductor element with a good reliability.

Furthermore, it is preferred that the heat-resisting base material is made of an organic polymer having a melting point of at least 250°C or a metal foil. In this case, under a high temperature, such as a soldering temperature of the circuit substrate, the occurrence of strain by the change of the linear expansion coefficient of the heat-resisting base material is prevented.

In particular, it is preferred that the organic resin constituting the sheet-form sealing material is made of polycarbodiimide as the main constituent. Thereby, the characteristics such as a low hygroscopic property, a flexibility, a high adhesive property and a high heat resistance are imparted to the sheet-form sealing material.

Also, it is preferred that the organic resin constituting the sheet-form sealing material contains an inorganic filler. In this case, the water absorption of the sheet-form sealing material can be restrained and also the occurrence of strain by the difference of the linear expansion coefficients of the semiconductor elements and the circuit substrate can be reduced.

The third aspect of this invention is a sheet-form sealing material used at flip-chip-mounting a semiconductor element onto a circuit substrate, characterized in that the sheet-form sealing material has an area being held at the inside of bumps for joining formed on the electrode portion of the peripheral portion of the semiconductor element and a thickness of at least the height of the joining bumps, and is made of an organic resin.

When the sheet-form sealing material of the third aspect of this invention is disposed at the inside of the joining bumps formed on a semiconductor element or at the inside of the bump-joined portion of the circuit substrate and at flip-chip-mounting, a semiconductor element is press-stuck onto a circuit substrate, the organic resin of the sheet-form sealing material having a thickness of at least the height of the bumps flows out to the peripheral portion of the joining bumps, whereby the space between the circuit substrate and the semiconductor element and the circumference of the joining bumps are sealed and also, the semiconductor element is adhered onto the circuit substrate.

Thereby, a semiconductor device excellent in the moisture resisting reliability and the cooling cycle resistance is obtained. Also, because the sheet-form sealing material can be stored at room temperature, the management thereof becomes easy. As the result thereof, a semiconductor device having a high reliability and an improved productivity can be easily produced.

The forth aspect of this invention is a semiconductor device, characterized in that flip chip mounting is made by carrying out bump joining and adhesion sealing with a sealing resin between a circuit substrate and a semiconductor element in a state that a sheet-form sealing material made of an organic resin having an area being held at the inside of bumps for joining formed on an electrode portion at the peripheral portion of the semiconductor element and a thickness of at least the height of the joining bumps is disposed at the inside of the joining bumps on the electrode portion of the semiconductor element or at the inside of the bump-joined portion of the circuit substrate.

Accordingly, the semiconductor device of this invention has the merit that in the case of bump joining, position matching of the joining bump is easy because the bump is exposed. Particularly, considering that in the case of a sheet-form sealing material containing a filler, when the sheet-form sealing material also exists on the bumps, position matching of bumps cannot substantially practiced, the effect of this invention using the sheet-form sealing material having the area being held within the inside between the joining bumps is large.

Because in the semiconductor device of this invention, adhesive sealing by bump-joining and a sealing resin between the circuit substrate and the semiconductor element is carried out in the state that the sheet-form sealing material made of an organic resin is disposed within the inside between the joining bumps on the electrode surface of the semiconductor element or within the inside between the bump-joining portions of the circuit substrate, the sheet-form sealing material having the thickness of at least the height of the joining bumps flows out to the peripheral portion of the joining bumps, and the semiconductor element is sealing-adhered to the circuit substrate in a state of covering the joining bumps. Thereby, a high moisture resisting reliability and a cooling cycle resistance are realized. In addition, since at bump joining, the height of the bump after joining becomes lower than the height of the bump before joining, by selecting the thickness of the sheet-form sealing material taking the above matter into account, the semiconductor device having a good appearance without excessive sealing material can be obtained.

The fifth aspect of this invention is a method of producing a semiconductor device, characterized in that flip chip mounting is practiced by carrying out bump joining and adhesive sealing with a sealing resin between a semiconductor element and a circuit substrate in a state that a sheet-form sealing material made of an organic resin having an area being held at the inside of bumps for joining formed on an electrode portion of the peripheral portion of the semiconductor element and a thickness of at least a height of the joining bumps is disposed at the inside of the joining bumps on the electrode surface of the semiconductor element. Accordingly, the method has a merit that because at bump joining, the bump is exposed, position matching of the joining bump is easy. Particularly, considering that in the case of a sheet-form sealing material containing a filler, when the sheet-form sealing material also exists on the bumps, position matching of bump cannot substantially practiced, the effect of this invention using the sheet-form sealing material having the area being held at the inside of the joining bumps is large.

Because according to the method of producing a semiconductor device of this invention, flip chip mounting is carried out in the state that the sheet-form sealing material made of an organic resin is disposed at the inside of the joining bumps on the surface of the semiconductor element, the sheet-form sealing material having the thickness at least the height of the joining bumps flows out to the peripheral portion of the joining bumps, the space between the circuit substrate and the semiconductor element and the circumference of the joining bumps are sealed in the state of covering the joining bumps, and the semiconductor element is adhered onto the circuit substrate.

Thereby, a semiconductor device excellent in the moisture resisting reliability and the cooling cycle resistance is obtained with a high productivity and a simple production process.

The sixth aspect of this invention is a method of producing a semiconductor device, characterized in that flip chip mounting is practiced by carrying out bump joining and adhesive sealing with the sealing resin between a semiconductor element and a circuit substrate in a state that a sheet-form sealing material made of an organic resin having an area being held at the inside of bumps for joining formed on an electrode portion of the peripheral portion of the semiconductor element and a thickness of at least the height of the joining bumps is disposed at the inside of the bump joined portions of the circuit substrate.

Because according to the method of producing a semiconductor device of this invention, flip chip mounting is carried out in the state that the sheet-form sealing material is disposed at the inside of the bump joined portions of the circuit substrate, the sheet-form sealing material having the thickness of at least the height of the joining bumps flows out to the peripheral portion of the joining bumps, the space between the circuit substrate and the semiconductor element and the circumference of the joining bumps are sealed, and the semiconductor element is adhered onto the circuit substrate.

Thereby, a semiconductor device excellent in the moisture resisting reliability and the cooling cycle resistance is obtained with a high productivity and a simple production process.

### Brief Description of the Drawings

Fig. 1 is the 1st step of the schematic cross-sectional view showing an embodiment of the sheet-form sealing material of this invention.
Fig. 2 is the 2nd step of the schematic cross-sectional view showing an embodiment of the production method of a semiconductor device of this invention.
Fig. 3 is the 3rd step of the schematic cross-sectional view showing the embodiment of the production method of a semiconductor device of this invention.
Fig. 4 is the 4th step of the schematic cross-sectional view showing the embodiment of the production method of a semiconductor device of this invention.
Fig. 5 is the 5th step of the schematic cross-sectional view showing the embodiment of the production method of a semiconductor device of this invention.
Fig. 6 is the 6th step of the schematic cross-sectional view showing the embodiment of the production method of a semiconductor device of this invention.
Fig. 7 is a schematic view showing plural semiconductor devices formed on a semiconductor wafer.

### Best Mode for Carrying Out the Invention

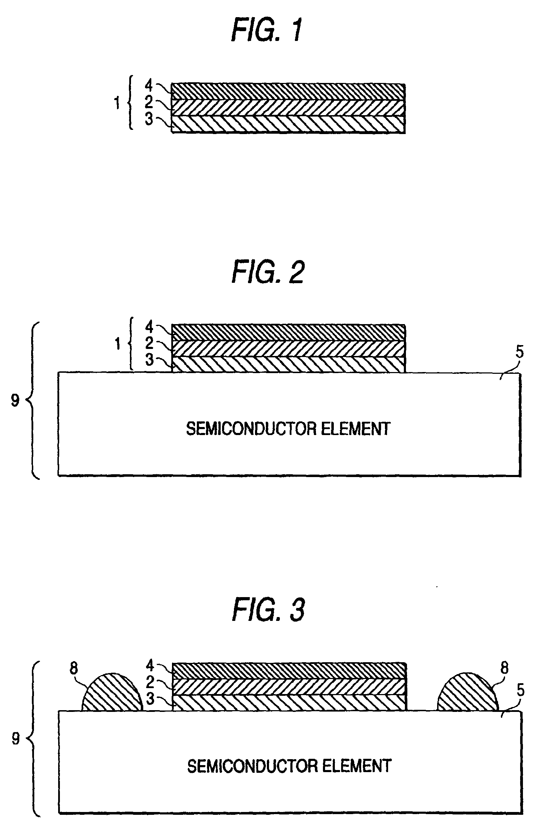

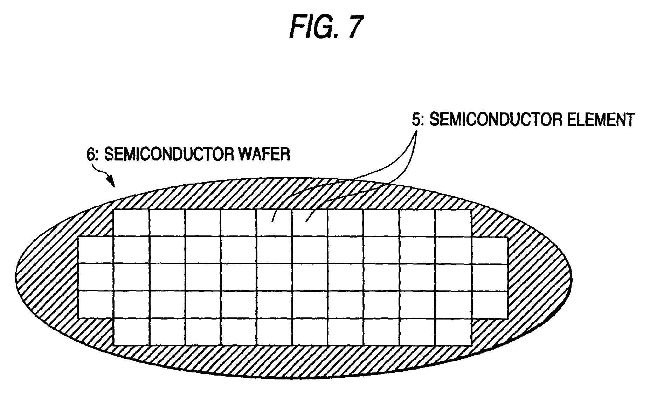

Fig. 1 to Fig. 6 are schematic views of the steps showing an embodiment of the production method of a semiconductor device of this invention. Also, Fig. 7 is a schematic view showing plural semiconductor devices formed on a semiconductor wafer. Then, an embodiment of the production method of a semiconductor device of this invention is explained by referring to Fig. 1 to Fig. 7.

In Fig. 1, an embodiment of using a laminated film 1 as the sheet-form sealing material is shown. The laminated film 1 is comprised of a heat resisting base material layer 2 as an intermediate layer having laminated on both surfaces each of adhesive layers 3 and 4.

The thickness of the laminated film 1 in the practical use is in the range of from 10 µm to 500 µm and the laminated film 1 has an area being held at the inside of the joining bumps formed on the electrode portion of the peripheral portion of the semiconductor element and a thickness of at least the height of the joining bumps. In particular, it is more preferred that the thickness of the laminated film 1 is from about 1 to 3 times the height of the joining bumps formed on the semiconductor element. However, in the case of flowing out the many sealing resin to the circumference of the joining bumps at heat-press-sticking described below, the thickness of the laminated film 1 may exceed 3 times the height of the joining bumps.

Because the height of the bumps formed at the electrode portion of a semiconductor element usually used is generally from 10 µm to 40 µm, the preferred thickness of the laminated film 1 is from 10 µm to 150 µm.

As the base material layer 2, a metal foil (metal layer) such as copper, 42 alloy, aluminum, etc., or an organic polymer having a melting point of at least 250°C, such as a polyimide base material, etc., is used. In particular, as the metal foil, copper is preferably used from the points of the mounting characteristics and the workability. The thickness of the base material layer 2 is preferably from 5 µm to 100 µm.

As the material for the adhesive layers 3 and 4, heat-resisting resins such as epoxy-based resins, polyimide-based resins, polyamide-based resins, silicone-based resins, etc., can be used but it is particularly preferred to use a polycarbodiimide shown by following formula (1) as the main constituent because of having the characteristics such as a low hygroscopicity, a flexibility, a high adhesive property, a high heat resistance, etc. In addition, -R- in the following formula (1) may be any one of structural formulae (A) to (D) shown below but is particularly preferably the fluorinated polycarbodiimide shown by the structural formula (D).

(̵R-N=C=N)̵ₙ (1)

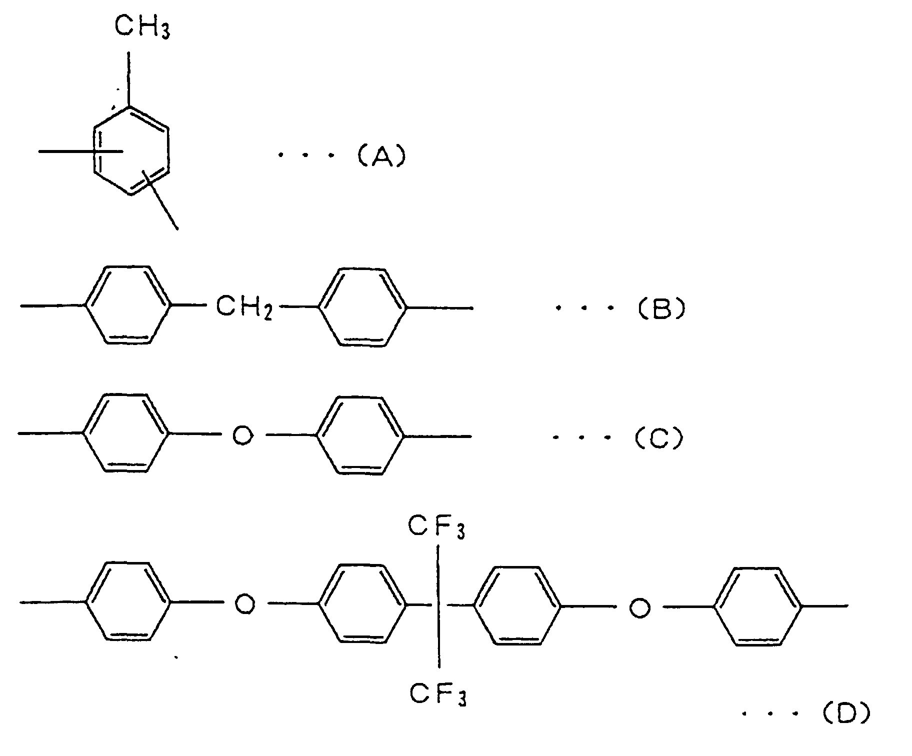

In the case of the polycarbodiimide as the main constituent, it is preferred that the content of the polycarbodiimide is from 40 to 90% by weight of the material constituting the adhesive layers 3 and 4. Also, the polycarbodiimide can be obtained by the methods disclosed in JP-A-2-292316 and JP-A-4-275359.

Also, if necessary, the adhesive layers 3 and 4 may contain an inorganic filler for the purposes of restraining a water-absorbing ratio and reducing the stain caused by the difference of the linear expansion coefficients of the semiconductor element and the circuit substrate. As the inorganic filler, for example, silica, alumina, titania, glass, iron oxide, and silicon nitride can be used. The content of the inorganic filler is preferably from 0 to about 90% by weight of the heat-resisting resin because if the content is larger than about 90% by weight of the heat-resisting resin, the adhesive property is lowered.

For the preparation of the laminated film 1, for example, a method of coating a solution of the polycarbodiimide resin is coated on both surfaces of a copper foil followed by drying may be used. Also, for example, a method of vapor-depositing copper onto a polycarbodiimide film of 50 µm in thickness and a method of superimposing a polycarbodiimide film on a copper foil and heating and pressing them may be used.

Then, as shown in Fig. 2, the laminated film 1 of Fig. 1 is stuck onto the upper surface (electrode-formed surface) of a semiconductor element 5. In this case, holes or slits are, if necessary, previously formed at definite portions of the laminated film 1 such that the surface electrode (pad) portions of the semiconductor element 5 are not covered by the laminated film 1.

There is no particular restriction on the method of sticking the laminated film 1 onto the semiconductor element 5, and for example, in the state that one adhesive layer 3 of the laminated film 1 is in contact with the upper surface of the semiconductor element 5, and not only the metal joint of the electrode portions is carried out but also the laminated film 1 can be heat-press stuck to the semiconductor element 5 at a pressure of from 5 kg/cm² to 40 kg/cm², for a time of from 5 seconds to 90 seconds, and at a temperature of from 210°C to 400°C by a flip chip bonder, etc. Also, after heat-melting one adhesive layer 3 of the laminated film 1, the adhesive layer 3 may be spread onto the upper surface of the semiconductor element 5.

Particularly, after heat-press-sticking the laminated film 1 onto the upper surface of the semiconductor element 5, by heat-curing the adhesive layer 3 by heating, the heat resistance may be improved. In this case, the laminated film 1 heat-press-stuck to the semiconductor element 5 is heated by an optional heating means such as a dryer, a hot blast dryer, a solder-mounting heating apparatus of semiconductor elements, etc. The heating temperature is set in the range of from 100°C to 360°C, and preferably from 110°C to 250°C.

When the adhesive layer 3 is made of polycarbodiimide, the polycarbodiimide is crosslinked and cured by heating described above to improve the heat resistance.

Sticking of the laminated film 1 to the semiconductor 5 may be carried out before cutting the semiconductor 5 from a semiconductor wafer 6 shown in Fig. 7 or may be carried out after cutting the semiconductor 5 from the semiconductor wafer 6. Thus, the semiconductor element-laminated film fixed body 9 is prepared as a flip chip member.

Then, as shown in Fig. 3, using a solder bump-forming apparatus, bumps 8 for joining made of a solder material, etc., are formed on the surface electrode of the semiconductor element 5. In this case, it is preferred that the height of the bump 8 is from 1/3 times to 1 times the thickness of the laminated film 1.

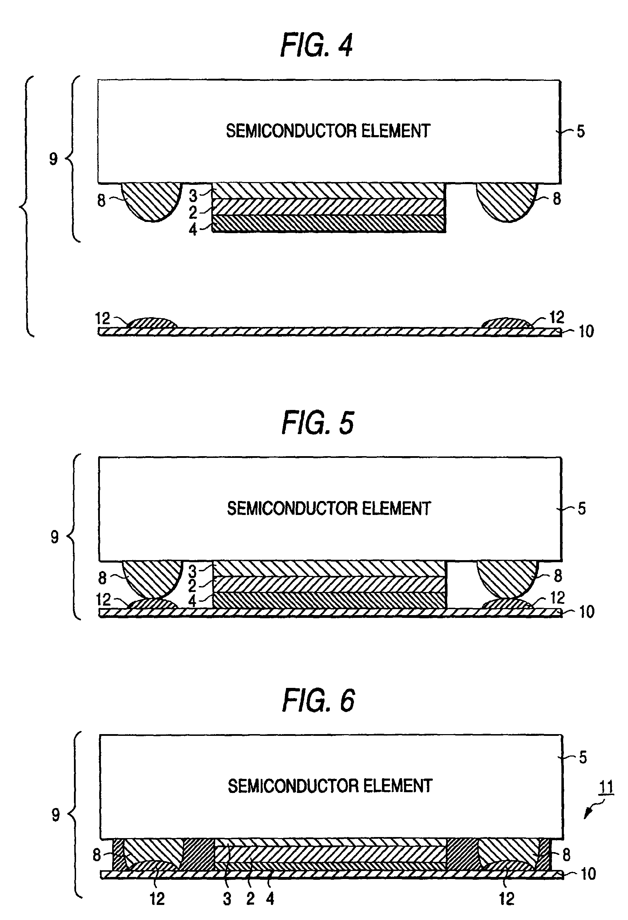

Thereafter, as shown in Fig. 4, the bumps 8 of the semiconductor element-laminated film fixed body 9 are position-matched with circuit wires 12 of a circuit substrate 10 and as shown in Fig. 5, by flip chip mounting, the semiconductor element 5 is mounted onto the circuit substrate 10 with the laminated film 1 between them. In this case, as shown in Fig. 6, the heat-resisting resin of the adhesive layers 3 and 4 of the laminated film 1 is spread in the space between the semiconductor 5 and the circuit substrate 10 excluding the regions of the bumps 8 and the circuit wires 12.

Thus, a semiconductor device 11 wherein the semiconductor element 5 is stuck onto the circuit substrate 10 with the laminated film 1 is prepared.

According to the production method of a semiconductor device of this invention, by sticking the laminated film 1 onto the surface of the semiconductor element 5, at flip chip mounting, the sealing resin can be filled in the space between the semiconductor element 5 and the circuit substrate 10 and also the semiconductor element 5 can be easily adhered onto the circuit substrate 10. Thereby, the production of a semiconductor device 11 becomes easy. In this case, because the laminated film 1 is disposed within the inside between the bumps 8, at adhesive sealing, the sealing material of the adhesive layers 3 and 4 flows out from the inside to the outside, whereby bubbles do not remain in the adhesive layers 3 and 4, and a semiconductor device 11 having a high reliability is obtained. Also, because the laminated film 1 exist within the inside between the bumps 8, there is an effect that at bump joining the semiconductor element 5 and the circuit substrate 10, position matching becomes easy.

Also, because the laminated film 1 can be stored at room temperature, the management becomes easy. Also, in this invention, a coating work of a liquid thermosetting resin onto the circuit substrate 10 by dispenser becomes unnecessary. Furthermore, because the base material layer 2 functions as a support for the adhesive layers 3 and 4, the handling property is improved. Therefore, the productivity of the semiconductor device 11 is improved.

Also, because each of the adhesive layers 3 and 4 is formed on both the surfaces of the base material layer 2 of the laminated film 1, the adhesive property of the laminated film 1 with the semiconductor element 5 and the circuit substrate 10 becomes good. Furthermore, because the base material layer 2 is sandwiched by the adhesive layers 3 and 4, the occurrence of warpage is prevented. Thus, the reliability of the semiconductor device 5 is improved.

In addition, in the above-described embodiment, the case of constituting the flip chip member by sticking the laminated film 1 to the inside of the bumps 8 on the electrode surface of the semiconductor element 5 was explained, but the flip chip members may be constituted by sticking the laminated film 1 to the inside of the bump-joined portions of the circuit substrate 10.

### Example

The invention is described more practically by the following example.

In the example, the semiconductor device 1 of this example was prepared by the production method shown in Fig. 1 to Fig. 6. In addition, the height of the bumps was 30 µm. In the example, the laminated film 1 was formed as follows.

First, by reacting 5.0 g of 2,2'-bis[(4-isocyanate phenoxy)phenyl]hexafluoropropane (BIPF) with 30 mg of a carbodiimidation catalyst (1-phenyl-3-methyl-2-phosphorene oxide) in 50 ml of tetrahydrofuran at 60°C for 15 hours, a polycarbodiimide resin solution was obtained. The polycarbodiimide resin solution was coated on both surfaces of a copper foil of 35 µm in thickness and dried at 100°C for 15 minutes to obtain a laminated film 1 of a three-layer structure. The thickness of each of the polycarbodiimide layers of the laminated film 1 was 50 µm.

On the other hand, as a sample of a comparative example, a semiconductor device having the same construction as above was prepared using a liquid epoxy resin which was a liquid thermosetting resin in place of the laminated film 1.

About the semiconductor devices of the example of this invention and the comparative example, a temperature cycle test (TCT) of from -50°C/5 minutes to 150°C/5 minutes was carried out and the occurred number of releasing of the semiconductor element from the circuit substrate was measured. The measurement results thereof are shown in Table 1.

**Table 1**

| | Cycle Number | Example | Comparative Example |
|---|---|---|---|
| Occurred Number of Releasing in TCT (No./10) | 200 | 0 | 5 |
| | 400 | 1 | 10 |
| | 800 | 1 | 10 |

As shown in Table 1, in the comparative example, the occurred number of releasing became 5 in 10 samples at 200 cycles and became 10 in 10 samples at 400 cycles and 800 cycles. On the other hand, in the example of this invention, the occurred number of releasing became 0 in 10 samples at 200 cycles and became 1 in 10 samples at 400 cycles and 800 cycles.

From the results, it has been confirmed that in the semiconductor devices of the example of this invention, the occurred number of releasing is far less as compared with those of the semiconductor devices of the comparative example and the reliability is improved.

### Industrial Applicability

As described above in detail, according to the present invention, a flip chip member capable of producing a semiconductor device having a high reliability with a high productivity by flip chip mounting; a seat-form sealing material used for the flip chip member; a semiconductor device having a high reliability capable of being produced with a high productivity by flip chip mounting; and a method of producing semiconductor devices having a high reliability with a high productivity by flip chip mounting are provided.

## Claims

1. A flip chip member comprising a semiconductor element and a sheet-form sealing material made of an organic resin, characterized in that the sheet-form sealing material has an area being held at the inside of bumps for joining formed on the electrode portion of the peripheral portion of the semiconductor element and a thickness of at least the height of the joining bumps, and is disposed at the inside of the above-described joining bumps on the electrode surface of the semiconductor element.

2. A flip chip member comprising a circuit substrate capable mounting a semiconductor element and a sheet-form sealing material made of an organic resin, characterized in that the sheet-form sealing material has an area being held at the inside of bumps for joining formed on the electrode portion of the peripheral portion of the semiconductor element and a thickness of at least the height of the joining bumps, and is disposed at the inside of the bump-joined portions of the above-described circuit substrate.

3. A flip chip member according to claim 1 or 2 further characterized in that the above-described sheet-form sealing material has a thickness of from 1 times to 3 times the height of the joining bumps formed on the electrode portion of the peripheral portion of the above-described semiconductor element.

4. A flip chip member according to claim 1, 2, or 3 further, characterized in that the above-described sheet-form sealing material is comprised of a heat-resisting base material having formed on both surfaces thereof a sealing material layer made of an organic resin as the main constituent.

5. A flip chip member according to claim 4 further, characterized in that the above-described sheet-resisting base material is made of an organic polymer having a melting point of at least 250°C or a metal foil.

6. A flip chip member according to any one of claims 1 to 5 further, characterized in that the organic resin constituting the above-described sheet-form sealing material is made of polycarbodiimide as the main constituent.

7. A flip chip member according to any one of claims 1 to 6 further, characterized in that the organic resin constituting the above-described sheet-form sealing material contains an inorganic filler.

8. A sheet-form sealing material used at flip-chip-mounting a semiconductor element onto a circuit substrate, characterized in that the sheet-form sealing material has an area being held at the inside of bumps for joining formed on the electrode portion of the peripheral portion of the semiconductor element and a thickness of at least the height of the joining bumps, and is made of an organic resin.

9. A semiconductor device, characterized in that flip chip mounting is made by carrying out bump joining and adhesion sealing with a sealing resin between a circuit substrate and a semiconductor element in a state that a sheet-form sealing material made of an organic resin having an area being held at the inside of bumps for joining formed on an electrode portion at the peripheral portion of the semiconductor element and a thickness of at least the height of the joining bumps is disposed at the inside of the joining bumps on the electrode portion of the above-described semiconductor element or at the inside of the bump-joined portions of above-described circuit substrate.

10. A method of producing a semiconductor device, characterized in that flip chip mounting is practiced by carrying out bump joining and adhesive sealing with a sealing resin between a semiconductor element and a circuit substrate in a state that a sheet-form sealing material made of an organic resin having an area being held at the inside of bumps for joining formed on an electrode portion of the peripheral portion of the semiconductor element and a thickness of at least a height of the joining bumps is disposed at the inside of the joining bumps on the electrode surface of the above-described semiconductor element.

11. A method of producing a semiconductor device, characterized in that flip chip mounting is practiced by carrying out bump joining and adhesive sealing with a sealing resin between a semiconductor element and a circuit substrate in a state that a sheet-form sealing material made of an organic resin having an area being held at the inside of bumps for joining formed on an electrode portion of the peripheral portion of the semiconductor element and a thickness of at least the height of the joining bumps is disposed at the inside of the bump joined portions of the circuit substrate.
